# EUROPEAN PATENT APPLICATION

(11) **EP 1 599 074 A1**
(43) Date of publication of application: **23.11.2005**
(21) Application number: 04715469.5
(22) Date of filing: 27.02.2004
(51) Int. Cl.: H05B 33/22, H05B 33/14

(54) **ORGANIC ELECTROLUMINESCENT DEVICE**

(30) Priority: 27.02.2003 JP 2003050584; 11.04.2003 JP 2003107202
(71) Applicant: KABUSHIKI KAISHA TOYOTA JIDOSHOKKI, Kariya-shi, Aichi-ken 448-8671 (JP)
(72) Inventor: NAGARA, Yoshiaki, Kabushiki K. Toyota Jidoshokkki, Kariya-shi, Aichi 448867 (JP)
(74) Representative: TBK-Patent
(86) International application number: PCT/JP2004/002386
(87) International publication number: WO 2004/077889

(57) **Abstract**

The organic EL device of the present invention includes a plurality of organic compound-containing layers provided between a cathode and an anode. Of two of the organic compound-containing layers adjacent to each other, one layer positioned nearer the anode has electron mobility lower than that of the other layer positioned nearer the cathode. Accordingly, the organic EL device of the present invention has a high luminous efficiency and a long half-life of the initial luminance.

## Description

### TECHNICAL FIELD

The present invention relates to an organic electroluminescent device (organic EL device).

### BACKGROUND ART

Organic EL devices have been attracting attention as next-generation display devices. Generally, organic EL devices are fabricated by forming an anode composed of a transparent conductive material such as indium tin oxide (ITO) on a glass substrate and laminating, on the anode, a hole injection region, a hole transport region, a light emission region, an electron transport region and a cathode in that order. Organic EL devices with such configuration emit light upon application of a direct-current voltage between the anode and the cathode. Specifically, when a direct-current voltage is applied between the anode and the cathode, holes are injected from the anode and electrons are injected from the cathode. Holes move to the light emission region through the hole injection region and the hole transport region, while electrons move to the light emission region through the electron transport region. Light is then emitted by recombination of holes and electrons in the light emission region.

For organic EL devices, high efficiency and long lifetime are required. Under such circumstances, as an electron transport region material, for example, materials having high electron mobility, such as silole derivatives disclosed in Japanese Laid-Open Patent Publication No. 09-87616 and Japanese Laid-Open Patent Publication No. 09-194487 and phenanthroline derivatives disclosed in Japanese Laid-Open Patent Publication No. 2001-267080 and Japanese Laid-Open Patent Publication No. 2001-155862 have been attracting attention.

Although organic EL devices using a silole derivative or a phenanthroline derivative have a high efficiency, the problem is that an exciplex or a charge-transfer complex tends to be formed with adjacent layers due to the high electron mobility. When at least one material of the organic compound-containing layers of an organic EL device forms an exciplex or a charge-transfer complex, these excitons have weak light emission, and this results in a low efficiency and a shortened half-life of the initial luminance of the organic EL device. The half-life of the initial luminance is a standard that represents the lifetime of an organic EL device by referring to the time required for the luminance of the organic EL device to be reduced to half of the initial luminance when a fixed amount of current is continuously applied to the organic EL device. Generally, the longer the half-life of the initial luminance of an organic EL device, the longer the lifetime of the organic EL device.

### DISCLOSURE OF THE INVENTION

An object of the present invention is to provide an organic EL device that has a high luminous efficiency and a long half-life of the initial luminance.

To achieve the above-mentioned object, the following organic EL device is provided according to an embodiment of the present invention. The organic EL device includes a cathode, an anode and a plurality of organic compound-containing layers provided between the cathode and the anode. Of two of the organic compound-containing layers adjacent to each other, an organic compound-containing layer positioned nearer the anode has electron mobility lower than that of an organic compound-containing layer positioned nearer the cathode.

The above-described configuration of organic compound-containing layers of an organic EL device can provide an organic EL device which has a long half-life of the initial luminance and a high luminous efficiency. As a device similar to such organic electroluminescent device, an invention described in Japanese Laid-Open Patent Publication No. 2001-155862 is known. The major point of this invention is that an organic light emission layer has dual carrier transport capabilities of an electron transport capability and a hole transport capability, gradually varying from a region of high hole transport capability to a region of high electron transport capability in the direction of the thickness of the layer. However, in the invention described in Japanese Laid-Open Patent Publication No. 2001-155862, the carrier transport capabilities involve only the organic light emission layer. In the present invention, on the contrary, the attention is focused on the electron mobility of all organic compound-containing layers interposed between a pair of electrodes, and there is a great difference in this respect.

According to another embodiment of the present invention, the following organic EL device is provided. The organic EL device includes a cathode, an anode, and a light emission region and an electron transport region which are provided between the cathode and the anode. The light emission region and the electron transport region are adjacent to each other. The electron transport region is comprised of a plurality of organic compound-containing layers. Of the organic compound-containing layers, an organic compound-containing layer in contact with the light emission region contains a quinolinolato metal complex.

As used herein, "electron mobility" and "hole mobility" mean electron mobility and hole mobility measured when an electric field with a predetermined intensity is applied to an organic compound. In this regard, the intensity of the electric field applied upon the measurement of the electron mobility needs to be within the range of the intensities of the electric field applied when an organic EL device is actually used.

The "electron transport region" may have at least a capability of transporting electrons.

The "hole transport material" means a material in which the hole mobility is 50 times or greater than the electron mobility, or a material such that only the hole mobility is measurable but the electron mobility is not measurable according to a time of flight (TOF) method. The TOF method is a method for measuring hole mobility and electron mobility by irradiating the surface of a sample with pulse light and measuring the transient current generated by carriers moving within the sample, which were produced by the pulse light.

### BRIEF DESCRIPTION OF THE DRAWINGS

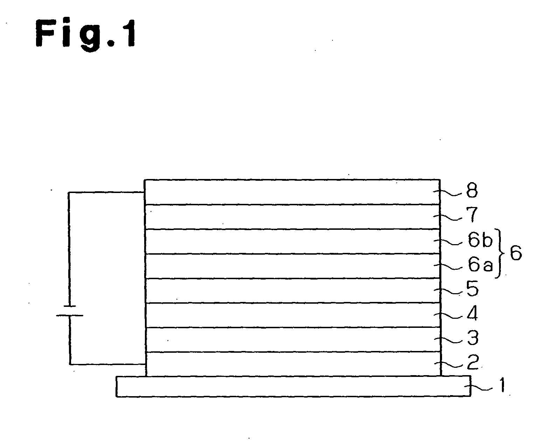

Fig. 1 is a cross-sectional view illustrating an organic EL device according to an embodiment of the present invention.

### BEST MODE FOR CARRYING OUT THE INVENTION

Hereinafter, one embodiment of the present invention will be described referring to Fig. 1.

In Fig. 1, reference numeral 1 denotes a substrate, reference numeral 2 denotes an anode, reference numeral 3 denotes a hole injection region, reference numeral 4 denotes a hole transport region, reference numeral 5 denotes a light emission region, reference numeral 6 denotes an electron transport region, reference numeral 6a denotes a first electron transport layer, reference numeral 6b denotes a second electron transport layer, reference numeral 7 denotes a cathode interface region and reference numeral 8 denotes a cathode.

The hole injection region 3 and the hole transport region 4 are not indispensable, but the presence of these layers further improves the luminous efficiency and the half-life of the initial luminance of an organic EL device.

The substrate 1 holds the organic EL device and the material thereof is not particularly limited. The substrate 1 may be a glass plate, a plastic sheet, a plastic film, a metal plate or a metal foil, or may be formed of a ceramic material such as silicon. The plastic sheet and the plastic film are preferably those of polyethylene terephthalate, polycarbonate or polymethacrylate because they have an excellent moisture barrier property, impact resistance, heat resistance and surface smoothness. In the case of a plastic substrate 1, a silicon nitride film, a silicon oxide film or a silicon oxynitride film may be formed on the surface of the substrate 1 in order to improve moisture barrier properties. In the case of a bottom emission organic EL device in which light from the light emission region 5 is emitted through the substrate 1, the substrate 1 must be able to transmit light in the visible region.

The anode 2 has a function of injecting holes into the hole injection region 3. The material for the anode 2 may be any of those which have a small electric resistance and a large work function, e.g., metals, alloys, electrically conductive compounds and a mixture thereof, which are of any kind. Examples of materials for the anode 2 include metal oxides such as ITO, indium zinc oxide (IZO), tin oxide, zinc oxide and a mixed material of zinc oxide and indium oxide, and titanium nitride; metal nitrides; metals such as gold, platinum, silver, copper, aluminum, nickel, lead, chromium, molybdenum, tungsten, tantalum and niobium; and conductive polymers such as polyaniline, polythiophene, polypyrrole and polyphenylene vinylene. The anode 2 may be composed of a single material or plural materials. The anode 2 may have a thickness of about 10 nm to 1 µm, preferably 10 nm to 300 nm. The anode 2 is formed, for example, by a sputtering method, an ion plating method, a vacuum vapor deposition method or a spin coat method.

The hole injection region 3 has functions of efficiently injecting holes injected from the anode 2 into the hole transport region 4 and improving adhesiveness between the anode 2 and functional regions containing organic compounds. The material used for the hole injection region 3 is required to have excellent adhesion to the anode 2, a low ionization potential and a high glass transition temperature. It is desired that the hole injection region 3 has electron mobility lower than that of the hole transport region 4. Examples of materials for the hole injection region 3 include phthalocyanine derivatives, porphyrin derivatives, polyphenylene vinylene derivatives, starburst amine derivatives, polyaniline and polythiophene. Of these compounds, those which suitably satisfy the above-mentioned requirements include copper phthalocyanine (CuPc) and metal-free phthalocyanine which are phthalocyanine derivatives, and 4,4',4"-tris(3-methylphenylphenyl-amine)triphenylamine which is a starburst amine derivative. The hole injection region 3 may be composed of a single material or plural materials. The hole injection region 3 may have a thickness of about 5 nm to 100 nm, preferably 10 nm to 50 nm. The hole injection region 3 is formed, for example, by a vacuum vapor deposition method, a spin coat method or a dip method.

The hole transport region 4 has a function of efficiently transporting holes injected from the hole injection region 3 into the light emission region 5. The material used for the hole transport region 4 is required to have ease in hole injection from the hole injection region 3 and efficient transportation of the injected holes into the light emission region 5. It is preferred that the hole transport region 4 has electron mobility lower than that of the light emission region 5. Examples of materials for the hole transport region 4 include triarylamine derivatives, compounds containing a triphenylamine structure in the main chain and/or the side chain as a recurring unit, triphenylmethane derivatives, hydrazone derivatives, oxazole derivatives, oxadiazole derivatives, triazole derivatives, fluorenyl diphenylamine derivatives, benzidine derivatives, pyrazoline derivatives, stilbene derivatives, styrylamine derivatives, polyphenylene vinylene derivatives, carbazole derivatives, phenylenediamine derivatives and spiro compounds. The material for forming the hole transport region 4 may also be those listed above as materials for the hole injection region 3. Of these compounds, those which suitably satisfy the above-mentioned requirements include triphenylamine, dimers, trimers, tetramers and pentamers of triphenylamine, which are triarylamine derivatives; N,N'-dinaphthyl-N,N'-diphenyl benzidine, which is a benzidine derivative; and 4,4'-N,N'-dicarbazole biphenyl and poly(N-vinylcarbazole), which are carbazole derivatives. The hole transport region 4 may be composed of a single material or plural materials. The hole transport region 4 may have a thickness of about 5 nm to 100 nm, preferably 10 nm to 50 nm. The hole transport region 4 is formed, for example, by a vacuum vapor deposition method, a spin coat method or a dip method.

In the light emission region 5, organic materials emit light. Specifically, holes which passed through the hole injection region 3 and the hole transport region 4 and electrons which passed through the cathode interface region 7 and the electron transport region 6 are recombined in the light emission region 5 to form excitons, and light emission occurs when they return to a ground state. The material used for the light emission region 5 is required to have a high fluorescent quantum efficiency, capability of efficiently transporting holes and/or electrons and a high glass transition temperature. The material for forming the light emission region 5 is not particularly limited as long as it satisfies the above-mentioned requirements. Examples thereof include distyrylarylene derivatives, distyrylbenzene derivatives, distyrylamine derivatives, quinolinolato metal complexes, triarylamine derivatives, azomethine derivatives, oxadiazole derivatives, pyrazoloquinoline derivatives, silole derivatives, naphthalene derivatives, anthracene derivatives, dicarbazole derivatives, perylene derivatives, oligothiophene derivatives, coumarin derivatives, pyrene derivatives, tetraphenyl butadiene derivatives, benzopyran derivatives, europium complexes, rubrene derivatives, quinacridone derivatives, triazole derivatives, benzoxazole derivatives and benzothiazole derivatives. Of these compounds, those which suitably satisfy the above-mentioned requirements include tris-(8-quinolinolato)aluminum (Alq3) and bis(2-methyl-8-quinolinolato)(p-phenylphenolato)aluminum (BAlq), which are quinolinolato metal complexes; triphenylamine tetramers, which are triarylamine derivatives; and 4,4'-bis(2,2'-diphenylvinyl)biphenyl (DPVBi), which is a distyrylarylene derivative. The light emission region 5 may be composed of a single organic compound-containing layer or a plurality of organic compound-containing layers. In addition, each organic compound-containing layer comprising the light emission region 5 may be composed of a single material or a plurality of materials. For improving the luminous efficiency and the half-life of the initial luminance of the organic EL device, a few % of a guest compound is usually doped in the host compound, but such doping is not indispensable. When doping is conducted, the concentration of the guest compound in the light emission region 5 needs not be uniform. For example, by making the concentration of the guest compound gradient in the thickness direction of the organic compound-containing layers, the concentration of the guest compound may be made to vary so that the electron mobility on the cathode side is greater than the electron mobility on the anode side in the organic compound-containing layers. The light emission region 5 may have a thickness of about 1 nm to 100 nm, preferably 10 nm to 50 nm. The light emission region 5 is formed, for example, by a vacuum vapor deposition method.

The electron transport region 6 has functions of efficiently transporting electrons injected from the cathode 8 into the light emission region 5 and preventing excitons generated in the light emission region 5 from being scattered and quenched at the cathode 8. In this embodiment, the electron transport region 6 is composed of two organic compound-containing layers of a first electron transport layer 6a and a second electron transport layer 6b. In short, in the organic electroluminescent device of this embodiment, two of the plurality of organic compound-containing layers comprise the electron transport region.

Hereinafter, the first electron transport layer 6a and the second electron transport layer 6b are described in detail.

The first electron transport layer 6a is disposed to be adhered to the light emission region 5 and has a function of transporting electrons to the light emission region 5. As a material of the first electron transport layer 6a, compounds which do not form an exciplex or a charge-transfer complex with the light emission region 5 are preferable and the electron mobility is preferably higher than that of the light emission region 5. As such material, quinolinolato metal complexes are particularly desirable.

As such quinolinolato metal complexes, complexes which have, as a ligand, 8-quinolinolato, 2-methyl-8-quinolinolato, 4-methyl-8-quinolinolato, 5-methyl-8-quinolinolato, 3,4-dimethyl-8-quinolinolato, 4-ethyl-8-quinolinolato, 4,5-dimethyl-8-quinolinolato, 4,6-dimethyl-8-quinolinolato, 4-methoxy-8-quinolinolato, 10-benzo[h]quinolinolato, benzo[f]-8-quinolinolato, dimers of 8-quinolinolato and 7-propyl-8-quinolinolato, and have aluminum, beryllium, zinc, magnesium, gallium, indium, copper, calcium, tin or lead as a central metal, are preferably used. More specific examples of such quinolinolato metal complex include Alq3, BAlq, tris(2-methyl-8-quinolinolato) aluminum, tris(5-methyl-8-quinolinolato) aluminum, mono(9-methyl-8-quinolinolato)bis(8-quinolinolato) aluminum, mono(4-ethyl-8-quinolinolato)mono(4-methyl-8-quinolinolato)mono(8-quinolinolato) aluminum, tris(3,4-dimethyl-8-quinolinolato) aluminum, tris(4-methoxy-8-quinolinolato) aluminum, tris(4,5-dimethyl-8-quinolinolato) aluminum, tris(4,6-dimethyl-8-quinolinolato) aluminum, tris(5-chloro-8-quinolinolato) aluminum, tris(5-bromo-8-quinolinolato) aluminum, tris(5,7-dichloro-8-quinolinolato) aluminum, tris(5-cyano-8-quinolinolato) aluminum, tris(5-sulfonyl-8-quinolinolato) aluminum, tris(5-propyl-8-quinolinolato) aluminum, bis(8-quinolinolato) zinc, bis(2-methyl-8-quinolinolato) zinc, bis(2,4-dimethyl-8-quinolinolato) zinc, bis(2-methyl-5-chloro-8-quinolinolato) zinc, bis(2-methyl-5-cyano-8-quinolinolato) zinc, bis(3,4-dimethyl-8-quinolinolato) zinc, bis(4,6-dimethyl-8-quinolinolato) zinc, bis(5-chloro-8-quinolinolato) zinc, bis(5,7-dichloro-8-quinolinolato) zinc, bis(benzo[f]-8-quinolinolato) zinc, bis(8-quinolinolato) beryllium, bis(2-methyl-8-quinolinolato) beryllium, bis(2,4-dimethyl-8-quinolinolato) beryllium, bis(2-methyl-5-chloro-8-quinolinolato) beryllium, bis(2-methyl-5-cyano-8-quinolinolato) beryllium, bis(3,4-dimethyl-8-quinolinolato) beryllium, bis(4,6-dimethyl-8-quinolinolato) beryllium, bis(5-chloro-8-quinolinolato) beryllium, bis(4,6-dimethyl-8-quinolinolato) beryllium, bis(10-hydroxybenzo[h]quinolinolato) beryllium, bis(8-quinolinolato) magnesium, bis(2-methyl-8-quinolinolato) magnesium, bis(2,4-dimethyl-8-quinolinolato) magnesium, bis(2-methyl-5-chloro-8-quinolinolato) magnesium, bis(2-methyl-5-cyano-8-quinolinolato) magnesium, bis(3,4-dimethyl-8-quinolinolato) magnesium, bis(4,6-dimethyl-8-quinolinolato) magnesium, bis(5-chloro-8-quinolinolato) magnesium, bis(5,7-dichloro-8-quinolinolato) magnesium, bis(10-benzo[h]quinolinolato) magnesium, tris(8-quinolinolato) indium, 8-quinolinolato lithium, tris(5-chloro-8-quinolinolato) gallium, bis(5-chloro-8-quinolinolato) calcium, bis(2-methyl-8-quinolinolato)(triphenylsilanolato) aluminum, bis(2-methyl-8-quinolinolato)(diphenylmethylsilanolato) aluminum, bis(2-methyl-8-quinolinolato)(tert-butyldiphenylsilanolato) aluminum, bis(2-methyl-8-quinolinolato)(tris-(4,4-biphenyl)silanolato) gallium, bis(2-methyl-8-quinolinolato)(1-naphtholato) gallium, bis(2-methyl-8-quinolinolato)(2-naphtholato) gallium and bis(8-quinolinolato) copper.

The first electron transport layer 6a may contain at least a quinolinolato metal complex and for example, it may be formed by vapor co-deposition with other materials. When the first electron transport layer 6a is formed by vapor co-deposition, the concentration of the quinolinolato metal complex may be varied or uniform in the thickness direction of the first electron transport layer 6a. The first electron transport layer 6a may have a thickness of about 0.1 to 20 nm, preferably about 0.5 nm to 4 nm. The first electron transport layer 6a is formed, for example, by a vacuum vapor deposition method.

The second electron transport layer 6b has a function of efficiently transporting electrons to the first electron transport layer 6a. The material used for the second electron transport layer 6b is required to have electron mobility higher than that of the first electron transport layer 6a. Examples of preferred materials for the second electron transport layer 6b include silole derivatives, phenanthroline derivatives, triazole derivatives, oxazole derivatives, oxadiazole derivatives, quinoxaline derivatives, quinoline derivatives, pyrrole derivatives, benzopyrrole derivatives, tetraphenylmethane derivatives, pyrazole derivatives, thiazole derivatives, benzothiazole derivatives, thiadiazole derivatives, thionaphthene derivatives, spiro compounds, imidazoles derivatives, benzoimidazole derivatives and distyrylbenzene derivatives. Examples of more preferred materials include silole derivatives described in Japanese Laid-Open Patent Publication No. 09-87616 and Japanese Laid-Open Patent Publication No. 09-194487, and of these, specifically 2,5-bis(6'-(2',2"-bipyridyl-))-1,1-dimethyl-3,4-diphenylsilole and 2,5-bis(6'-(2',2"-bipyridyl))-1,1-dimethyl-3,4-bis(2-methylphenyl)silole are preferred. In addition, bathocuproin and bathophenanthroline, which are phenanthroline derivatives, and phenanthroline derivatives described in Japanese Laid-Open Patent Publication No. 2001-267080 are also more preferred as materials for the second electron transport layer 6b. The second electron transport layer 6b may have a thickness of about 1 to 100 nm, preferably about 1 to 50 nm. The second electron transport layer 6b is formed, for example, by a vacuum vapor deposition method.

The electron transport region 6 may not always be composed of two organic compound-containing layers, but may be composed of three or more organic compound-containing layers.

The cathode interface region 7 has functions of increasing the ability of electron injection from the cathode 8 to the second electron transport layer 6b and improving adhesion between the cathode 8 and the electron transport region 6. The material for the cathode interface region 7 is not particularly limited as long as it can impart the above-mentioned properties, and known materials may be used. Specifically, examples of materials for the cathode interface region 7 include fluorides, oxides, chlorides and sulfides of alkali metal or alkaline-earth metal, such as lithium fluoride, lithium oxide, magnesium fluoride, calcium fluoride, strontium fluoride and barium fluoride. The cathode interface region 7 may be composed of a single material or plural materials. The cathode interface region 7 may have a thickness of about 0.1 nm to 10 nm, preferably 0.3 nm to 3 nm. The cathode interface region 7 may have a uniform thickness throughout the region 7 or uneven thicknesses. The cathode interface region 7 may be island-shaped. The cathode interface region 7 is formed, for example, by a vacuum vapor deposition method.

The cathode 8 has a function of injecting electrons into the cathode interface region 7. The material used for the cathode 8 may be any of those that have a small electric resistance and a small work function, e.g., metals, alloys, electrically conductive compounds and a mixture thereof, which are of any kind. Examples of materials for the cathode 8 include metals such as gold, silver, copper, aluminum, indium, calcium and tin; and alloys like aluminum alloys such as aluminum-calcium alloy and aluminum-lithium alloy and magnesium alloys such as magnesium-silver alloy and magnesium-indium alloy. The material for the cathode 8 may also be those listed above as materials for the anode 2. The cathode 8 may be composed of a single material or plural materials. The cathode 8 may have a thickness of about 5 nm to 1 µm, preferably 10 nm to 500 nm. The cathode 8 is formed, for example, by a vacuum vapor deposition method, a sputtering method, an ion plating method or an electron beam vapor deposition method.

Of the anode 2 and the cathode 8, the electrode positioned nearer the side from which light is obtained than the light emission region 5, i.e., the electrode located nearer the light output surface of the organic EL device than the light emission region 5 needs to be transparent or translucent. It is preferable that the transparent or translucent electrode has a light transmission of not less than 10% in the visible light region.

The organic EL device illustrated in Fig. 1 is an example of an embodiment of the present invention, and the present invention is by no means limited to the organic EL device shown in Fig. 1 as long as there is no departure from the spirit of the present invention. For example, the organic EL device may have layers as listed in the following items (1) to (4) on the substrate 1. The layers shown in items (1) to (4) may be formed on the substrate 1 in order from the left or in order from the right.
(1) anode/hole injection region/light emission region/electron transport region/cathode interface region/cathode
(2) anode/hole injection region/hole transport region/light emission region/electron transport region/cathode
(3) anode/light emission region/electron transport region/cathode interface region/cathode
(4) anode/light emission region/electron transport region/cathode

### Examples

Hereinafter, the present invention is more specifically described by means of Examples, but it is obvious that the present invention is not to be construed as limited to these Examples.

### [Example 1]

A transparent glass substrate was used as the substrate 1. An anode 2 was formed on the substrate 1. The anode 2 was formed of ITO having a thickness of 190 nm. For cleaning the substrate before vapor depositing an organic layer, the substrate 1 was subjected to alkali cleaning followed by washing with pure water, dried and then subjected to ultraviolet-ozone cleaning. The substrate 1 was then placed in a vacuum chamber, and CuPc shown in formula 1 was vapor deposited on the ITO provided on the substrate 1 with a carbon crucible at a deposition rate of 0.1 nm/s under a vacuum of about 5.0 × 10⁻⁵ Pa to form a hole injection region 3 of 10 nm in thickness.

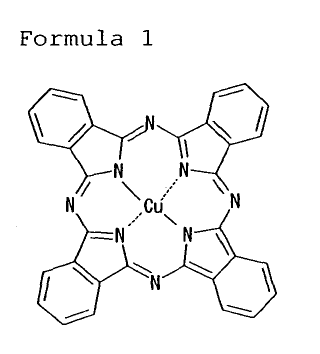

A triphenylamine tetramer shown in formula 2 was vapor deposited on the hole injection region 3 with a carbon crucible at a deposition rate of 0.1 nm/s under a vacuum of about 5.0 × 10⁻⁵ Pa to form a hole transport region 4 of 10 nm in thickness. The triphenylamine tetramer has electron mobility higher than that of CuPc which is the material for the hole injection region 3. For measuring the electron mobility, a thin film composed only of a material to be measured was formed and the measurement was conducted according to a TOF method.

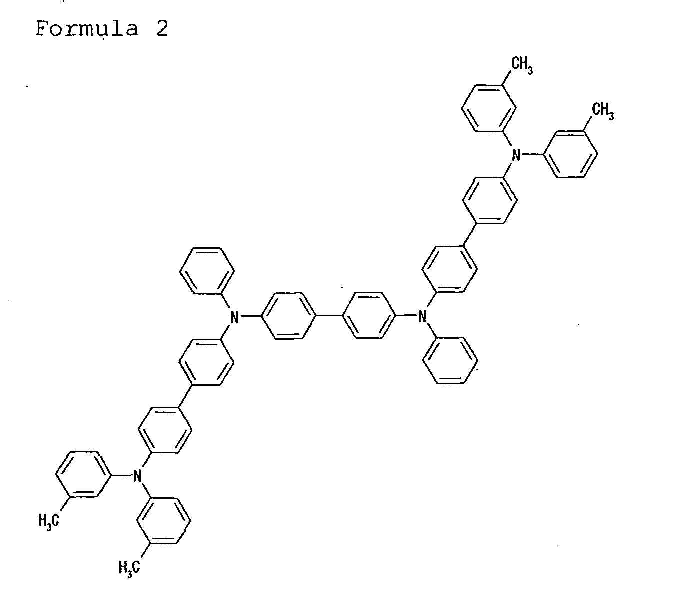

DPVBi (luminescent color: blue) shown in formula 3 was vapor deposited on the hole transport region 4 at a deposition rate of 0.1 nm/s under a vacuum of about 5.0 × 10⁻⁵ Pa to form a light emission region 5 of 30 nm in thickness. From the measurement of the hole mobility and the electron mobility according to a TOF method, DPVBi was proved to be a hole transport material. DPVBi has electron mobility higher than that of triphenylamine tetramer which is the material for the hole transport region 4.

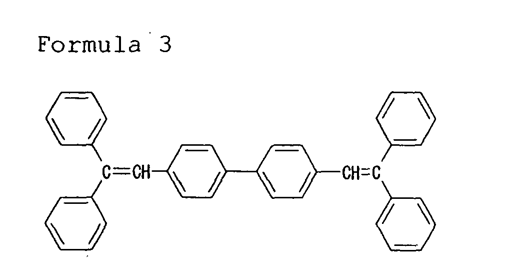

An electron transport region 6 composed of a first electron transport layer 6a and a second electron transport layer 6b was formed on the light emission region 5. The first electron transport layer 6a and the second electron transport layer 6b are arranged in this order on the light emission region 5. The first electron transport layer 6a was formed by vapor depositing Alq3 shown in formula 4, which is a quinolinolato metal complex, with a carbon crucible at a deposition rate of 0.01 nm/s under a vacuum of about 5.0 × 10⁻⁵ Pa to have a thickness of 4.0 nm. Alq3 has electron mobility higher than that of DPVBi which is the material for the light emission region 5.

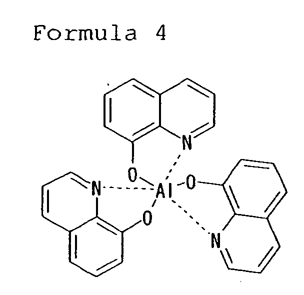

The second electron transport layer 6b was formed by vapor depositing 2,5-bis(6'-(2',2"-bipyridyl))-1,1-dimethyl-3,4-diphenylsilole (ETM) shown in formula 5, which is a silole derivative, with a carbon crucible at a deposition rate of 0.1 nm/s under a vacuum of about 5.0 × 10⁻⁵ Pa to have a thickness of 15 nm.

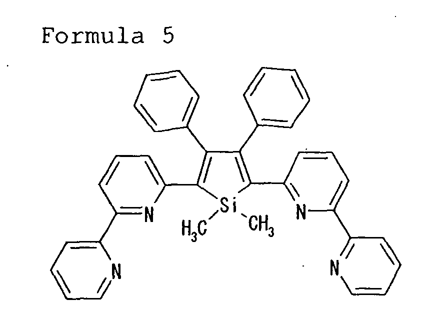

When the electron mobility of Alq3 comprising the first electron transport layer 6a and the electron mobility of ETM comprising the second electron transport layer 6b are compared, ETM has higher electron mobility.

After completion of formation of the second electron transport layer 6b, lithium fluoride was vapor deposited thereon with a carbon crucible at a deposition rate of 0.03 nm/s under a vacuum of about 5.0 × 10⁻⁵ Pa to form a cathode interface region 7 of 0.5 nm in thickness. Subsequently, aluminum was vapor deposited thereon with a tungsten boat at a deposition rate of 1 nm/s under a vacuum of about 5.0 × 10⁻⁵ Pa to form a cathode 8 of 100 nm in thickness.

### [Comparative Example 1]

In Comparative Example 1, a device was produced in the same manner as in Example 1 except that the hole injection region 3 was formed of TPTE and the hole transport region 4 was formed of CuPc. The hole injection region 3 was formed by vapor depositing TPTE with a carbon crucible at a deposition rate of 0.1 nm/s under a vacuum of about 5.0 × 10⁻⁵ Pa to have a thickness of 10.0 nm. The hole transport region 4 was formed by vapor depositing CuPc with a carbon crucible at a deposition rate of 0.1 nm/s under a vacuum of about 5.0 × 10⁻⁵ Pa to have a thickness of 10.0 nm. The CuPc has electron mobility lower than that of TPTE.

### [Comparative Example 2]

In Comparative Example 2, a device was produced in the same manner as in Example 1 except that the first electron transport layer 6a was formed of ETM and the second electron transport layer 6b was formed of Alq3. The first electron transport layer 6a was formed by vapor depositing ETM with a carbon crucible at a deposition rate of 0.1 nm/s under a vacuum of about 5.0 Pa to have a thickness of 4.0 nm. The second electron transport layer 6b was formed by vapor depositing Alq3 with a carbon crucible at a deposition rate of 0.1 nm/s under a vacuum of about 5.0 × 10⁻⁵ Pa to have a thickness of 15 nm. Alq3 has electron mobility lower than that of ETM.

### [Comparative Example 3]

In Comparative Example 3, a device was produced in the same manner as in Example 1 except that the light emission region 5 was formed of Alq3 and the first electron transport layer 6a was formed of DPVBi. The light emission region 5 is formed by vapor depositing Alq3 with a carbon crucible at a deposition rate of 0.1 nm/s under a vacuum of about 5.0 × 10⁻⁵ Pa to have a thickness of 30 nm. The first electron transport layer 6a was formed by vapor depositing DPVBi with a carbon crucible at a deposition rate of 0.1 nm/s under a vacuum of about 5.0 Pa to have a thickness of 4.0 nm. DPVBi has electron mobility lower than that of Alq3.

Table 1 shows the results of measuring the power efficiency, the current efficiency, the chromaticity x and the chromaticity y at a luminance of 1000 cd/m² and the half-life of the initial luminance of the organic EL devices of Example 1 and Comparative Examples 1 to 3. The luminance and chromaticity were measured using a luminance measurement apparatus (Luminance Meter BM 7 made by TOPCON CORPORATION). The half-life of the initial luminance refers to the time spent for the luminance of an organic EL device to be reduced to half of the initial luminance 2400 cd/m² when a fixed amount of current is continuously applied to the organic EL device.

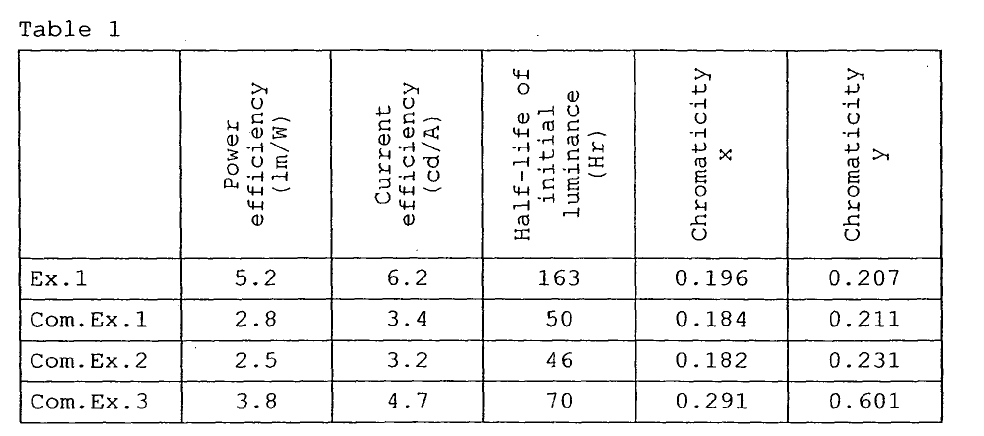

### (Evaluation)

Generally, current flowing through an organic material is considered to be influenced by space charge inside the organic material. It is thought that when two optional organic layers that are adjacent to each other are arranged so that the electron mobility of one organic layer positioned nearer the anode is higher than the electron mobility of the other organic layer positioned nearer the cathode, the space charge inside the organic material is disturbed, whereby the mobility of the entire organic layer is reduced and the luminous efficiency is decreased. It is also considered that when the luminous efficiency is decreased, a larger amount of current is necessary for achieving a predetermined luminance, and this shortens the half-life of the initial luminance. In the organic EL device of Comparative Example 1, CuPc comprising the hole transport region 4 has an electron mobility lower than that of TPTE comprising the hole injection region 3 adjacent thereto on the anode side; in the organic EL device of Comparative Example 2, Alq3 comprising the second electron transport layer 6b has an electron mobility lower than that of ETM comprising the first electron transport layer 6a adjacent thereto on the anode side; and in the organic EL device of Comparative Example 3, DPVBi comprising the first electron transport layer 6a has an electron mobility lower than that of Alq3 comprising the light emission region 5 adjacent thereto on the anode side. It is therefore considered that the organic EL devices of Comparative Examples 1 to 3 have, as shown in Table 1, a lower power efficiency, a lower current efficiency and a shorter half-life of the initial luminance as compared to the organic EL device of Example 1 which has a configuration such that one of adjacent organic layers positioned nearer the cathode has an electron mobility higher than that of the other organic layer.

### [Examples 2 to 7]

In Examples 2 to 7, the thickness of the first electron transport layer 6a (Alq3) was each 3.0 nm (Example 2), 2.5 nm (Example 3), 2.0 nm (Example 4), 1.5 nm (Example 5), 1.0 nm (Example 6) and 0.5 nm (Example 7). Devices were prepared in the same manner as in Example 1 except for the above.

### [Comparative Example 4]

In Comparative Example 4, a device was produced in the same manner as in Example 1, but without forming a first electron transport layer 6a.

Table 2 shows the results of measuring the power efficiency, the current efficiency, the chromaticity x and the chromaticity y at a luminance of 1000 cd/m² and the half-life of the initial luminance (initial luminance 2400 cd/m²) of the organic EL devices of Examples 1 to 7 and Comparative Example 4.

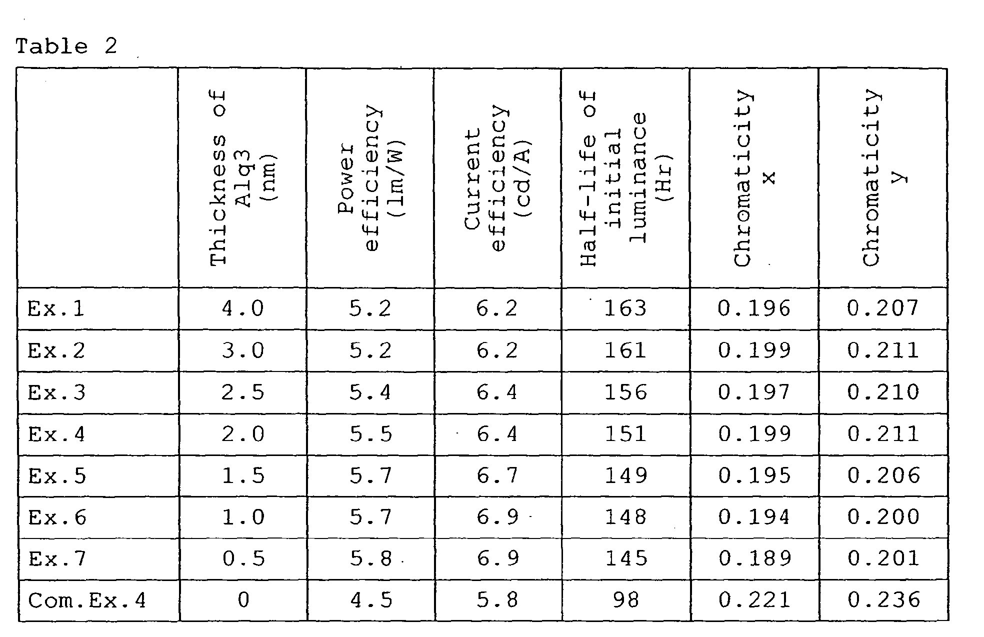

### (Evaluation)

As shown in Table 2, the organic EL devices of Examples 1 to 7 in which the first electron transport layer 6a was formed of Alq3 have improved power efficiency and current efficiency as compared to the organic EL device of Comparative Example 4 that has no first electron transport layer 6a. It is generally considered that when a material having high electron mobility and a material having high hole mobility are positioned so as to be adhered with each other, an exciplex or a charge-transfer complex tends to be formed, and when the compound contained in the organic EL device forms such exciplex or charge-transfer complex, the wavelength of the emitted light becomes longer. When the chromaticity y of the organic EL devices of Examples 1 to 7 and the chromaticity y of the organic EL device of Comparative Example 4 are compared, the organic EL device of Comparative Example 4 has a higher chromaticity y. A higher chromaticity y in a blue light emitting device means that the wavelength of the emitted light became longer. From this, it is considered that in the organic EL device of Comparative Example 4, an exciplex or a charge-transfer complex was formed in the neighborhood of the interface between ETM comprising the second electron transport layer 6b and DPVBi comprising the light emission region 5. In general, an exciplex or a charge-transfer complex has weak light emission. In the organic EL devices of Examples 1 to 7, however, formation of exciplex or charge-transfer complex at the interface between Alq3 comprising the first electron transport layer 6a and DPVBi comprising the light emission region 5 has been suppressed, and as an organic compound-containing layer which contains a material of which the electron mobility is higher than that of Alq3, which is a quinolinolato metal complex, is positioned nearer the cathode side, the electron mobility of the entire electron transport region 6 is increased. This seems to be the reason why the organic EL devices of Examples 1 to 7 have improved power efficiency and current efficiency as compared to the organic EL device of Comparative Example 4. In particular, the power efficiency and the current efficiency significantly improved when the first electron transport layer 6a has a thickness of 0.5 nm to 4 nm.

The organic EL device of Comparative Example 4 has a shorter half-life of the initial luminance than that of the organic EL devices of Examples 1 to 7. This seems to be because the organic EL device of Comparative Example 4 has lower current efficiency due to the formed exciplex. As compared to the organic EL devices of Examples 1 to 7 in which no exciplex is formed, the organic EL device of Comparative Example 4 requires a larger amount of current to achieve a predetermined luminance. Generally, the larger the amount of current flowing through an organic EL device, the shorter the half-life of the initial luminance. For such reason, it is considered that the organic EL device of Comparative Example 4 has a shorter half-life of the initial luminance than that of the organic EL devices of Examples 1 to 7. In particular, the half-life of the initial luminance is significantly improved when the first electron transport layer 6a has a thickness of 0.5 nm to 4 nm.

### [Examples 8 to 14]

In Examples 8 to 14, a device was produced under the same conditions as in Example 1 except that the second electron transport layer 6b was formed of bathocuproin represented by formula 6, which is a phenanthroline derivative. The thickness of the first electron transport layer 6a was 4.0 nm in Example 8, 3.0 nm in Example 9, 2.5 nm in Example 10, 2.0 nm in Example 11, 1.5 nm in Example 12, 1.0 in Example 13 and 0.5 nm in Example 14.

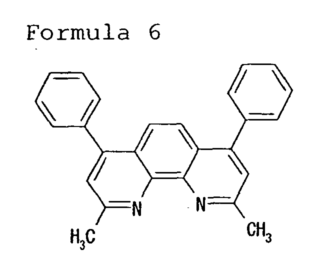

### [Comparative Example 5]

In Comparative Example 5, a device was produced in the same manner as in Examples 8 to 14, but without forming a first electron transport layer 6a.

Table 3 shows the results of measuring the power efficiency, the current efficiency, the chromaticity x and the chromaticity y at a luminance of 1000 cd/m² and the half-life of the initial luminance (initial luminance 2400 cd/m²) of the organic EL devices of Examples 8 to 14 and Comparative Example 5.

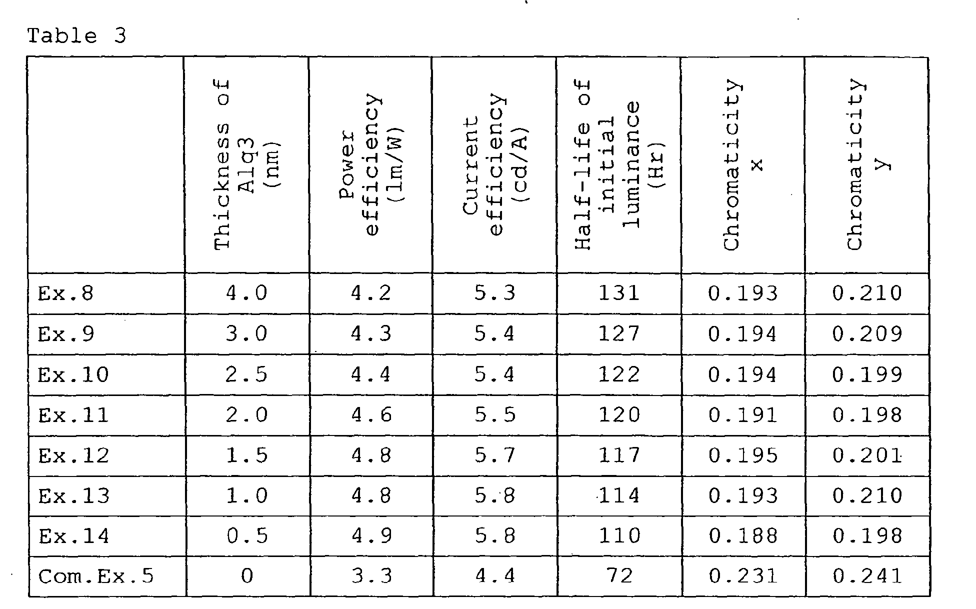

### (Evaluation)

As shown in Table 3, the organic EL devices of Examples 8 to 14 in which the first electron transport layer 6a was formed of Alq3 have improved power efficiency and current efficiency as compared to the organic EL device of Comparative Example 5 that has no second electron transport layer 6b. When the chromaticity y of the organic EL devices of Examples 8 to 14 and the chromaticity y of the organic EL device of Comparative Example 5 are compared, the organic EL device of Comparative Example 5 has a higher chromaticity y. A higher chromaticity y in a blue light emitting device means that the wavelength of the emitted light became longer. From this, it is considered that in the organic EL device of Comparative Example 5, bathocuproin comprising the second electron transport layer 6b and DPVBi comprising the light emission region 5 form an exciplex or a charge-transfer complex, but in the organic EL devices of Examples 8 to 14, formation of exciplex or charge-transfer complex has been suppressed; as a result, the organic EL devices of Examples 8 to 14 have improved power efficiency and current efficiency as compared to the organic EL device of Comparative Example 5. In particular, the power efficiency and the current efficiency significantly improved when the first electron transport layer 6a had a thickness of 0.5 nm to 4 nm.

The organic EL device of Comparative Example 5 has a shorter half-life of the initial luminance than that of the organic EL devices of Examples 8 to 14. This seems to be because the organic EL device of Comparative Example 5 has lower current efficiency due to the formed exciplex. As compared to the organic EL devices of Examples 8 to 14 in which no exciplex is formed, the organic EL device of Comparative Example 5 requires a larger amount of current to achieve a predetermined luminance. Generally, the larger the amount of current flowing through an organic EL device, the shorter the half-life of the initial luminance. For such reason, it is considered that the organic EL device of Comparative Example 5 has a shorter half-life of the initial luminance than the organic EL devices of Examples 8 to 14. In particular, the half-life of the initial luminance significantly improved when the first electron transport layer 6a had a thickness of 0.5 nm to 4 nm.

## Claims

1. An organic electroluminescent device **characterized by**:
a cathode and an anode; and
a plurality of organic compound-containing layers provided between the cathode and the anode, wherein, of two of the organic compound-containing layers adjacent to each other, an organic compound-containing layer positioned nearer the anode has electron mobility lower than that of an organic compound-containing layer positioned nearer the cathode.

2. The organic electroluminescent device according to claim 1, **characterized in that** the organic compound-containing layers are first organic compound-containing layers, wherein the organic electroluminescent device further includes a plurality of second organic compound-containing layers provided between the cathode and the anode, and wherein at least two of the second organic compound-containing layers comprise an electron transport region.

3. The organic electroluminescent device according to claim 1, **characterized in that** at least two of the organic compound-containing layers comprise an electron transport region.

4. The organic electroluminescent device according to claim 2 or 3, **characterized in that** at least one of the organic compound-containing layers other than the organic compound-containing layers comprising the electron transport region comprises at least one of a hole injection region, a hole transport region and a cathode interface region.

5. An organic electroluminescent device **characterized by**:
a cathode and an anode; and
a light emission region and an electron transport region which are provided between the cathode and the anode, wherein the light emission region and the electron transport region are adjacent to each other, wherein the electron transport region is comprised of a plurality of organic compound-containing layers, and wherein, of the organic compound-containing layers, an organic compound-containing layer in contact with the light emission region contains a quinolinolato metal complex.

6. The organic electroluminescent device according to claim 5, **characterized in that** the light emission region is comprises of one or a plurality of organic compound-containing layers, wherein the one organic compound-containing layer which comprises the light emission region or, of the plurality of organic compound-containing layers which comprise the light emission region, an organic compound layer positioned nearest the cathode contains a hole transport material, wherein the organic compound-containing layer which contains a quinolinolato metal complex is a first organic compound-containing layer, wherein the organic electroluminescent device further includes a second organic compound-containing layer positioned between the first organic compound-containing layer and the cathode, and wherein the second organic compound-containing layer contains a material which has electron mobility higher than that of the quinolinolato metal complex.

7. The organic electroluminescent device according to claim 6, **characterized in that** the material which has electron mobility higher than that of the quinolinolato metal complex is a silole derivative or a phenanthroline derivative.

8. The organic electroluminescent device according to claim 6 or 7, **characterized in that** the hole transport material is a distyrylarylene derivative.

9. The organic electroluminescent device according to any one of claims 5 to 8, **characterized in that** the organic compound layer which contains a quinolinolato metal complex has a thickness of 0.5 nm to 4 nm.
